# DEMANDE DE BREVET EUROPEEN

(11) **EP 3 940 401 A1**
(43) Date de publication de la demande: **19.01.2022**
(21) Numéro de dépôt: 21183634.1
(22) Date de dépôt: 05.07.2021
(51) Int. Cl.: G01R 31/28

(54) **CIRCUIT INTÉGRÉ ET PROCÉDÉ DE DIAGNOSTIC D'UN TEL CIRCUIT INTÉGRÉ**

(30) Priorité: 15.07.2020 FR 2007423
(71) Demandeur: STMicroelectronics (ALPS) SAS, 38000 Grenoble (FR); STMICROELECTRONICS (GRENOBLE 2) SAS, 38000 Grenoble (FR)
(72) Inventeur: AUVRAY, Etienne, 38850 CHARAVINES (FR); MELIS, Tommaso, 38000 GRENOBLE (FR); SIRITO-OLIVIER, Philippe, 38120 SAINT EGREVE (FR)
(74) Mandataire: Casalonga

(57) **Abrégé**

Selon un aspect, il est proposé un circuit intégré comprenant :
- des modules électroniques (ME), chaque module électronique étant configuré pour générer en sortie une tension de fonctionnement qui lui est propre lors d'un fonctionnement normal de ce module électronique,
- au moins un circuit électronique de contrôle (CC) comprenant un composant électronique émissif (EEC), chaque circuit électronique de contrôle (CC) étant disposé en sortie d'un module électronique (ME), ledit au moins un circuit électronique de contrôle (CC) et son composant électronique émissif (EEC) étant configurés de façon à permettre au composant électronique émissif (EEC) d'émettre un rayonnement lumineux en fonction de la tension en sortie de ce module électronique (ME) par rapport à ladite tension de fonctionnement, le circuit intégré étant configuré de sorte que le rayonnement lumineux pouvant être émis par ledit composant électronique émissif (EEC) puisse se diffuser jusqu'à une face extérieure du circuit intégré.

## Description

Des modes de réalisation et de mise en œuvre concernent les circuits intégrés et les procédés de diagnostic de tels circuits intégrés.

Un circuit intégré comprend généralement plusieurs modules électroniques, chaque module électronique étant configuré pour réaliser une fonction électronique donnée.

Ces modules électroniques peuvent subir des défaillances pouvant notamment résulter de la fabrication du circuit intégré ou bien de leur usure dans le temps.

Afin de corriger ces défaillances, il est tout d'abord essentiel d'identifier chaque module électronique défaillant du circuit intégré.

À ce titre, la microscopie d'émission est une méthode connue permettant d'identifier les modules électroniques défaillants d'un circuit intégré en analysant les rayonnements lumineux émis par les modules électroniques de ce circuit intégré.

En effet, les modules électroniques comprennent des composants électroniques pouvant émettre des rayonnements lumineux, notamment lors de leur fonctionnement, lorsqu'ils sont traversés par un courant électrique. Les rayonnements lumineux peuvent être visibles ou bien infrarouge. En particulier, ces rayonnements lumineux peuvent présenter une longueur d'ondes comprise entre 400nm (visible) et 1400nm (proche infrarouge).

Les composants électroniques pouvant émettre de tels rayonnements lumineux peuvent être des transistor MOS ou des diodes par exemple.

Ces rayonnements lumineux produits par les composants électroniques des différents modules électroniques se propagent jusqu'à une face extérieure du circuit intégré pouvant être observée depuis l'extérieur du circuit intégré.

Il est ainsi possible d'acquérir une image des rayonnements lumineux produits par les composants électroniques des modules électroniques afin d'analyser le circuit intégré.

Pour identifier les modules électroniques défaillants, il est possible de comparer des images des rayonnements lumineux produits par le circuit intégré défaillant analysé à des images des rayonnements lumineux produits par un circuit intégré fonctionnel identique au circuit intégré analysé.

Les images du circuit intégré défaillant peuvent différer des images du circuit intégré fonctionnel du fait que les modules électroniques défaillants du circuit intégré défaillant peuvent ne pas produire de rayonnement lumineux.

L'analyse des différences entre les images du circuit intégré défaillant et celles du circuit intégré fonctionnel peut alors permettre d'identifier les modules électroniques défaillants.

Néanmoins, cette méthode présente certaines limites. En effet, il est possible qu'une défaillance d'un module électronique implique que d'autres modules électroniques, bien que fonctionnels pris isolément, ne puissent pas fonctionner du fait que le module électronique est placé en amont de ces modules électroniques fonctionnels. Ces modules électroniques fonctionnels peuvent alors ne pas produire de rayonnements lumineux. Il est alors difficile d'identifier le module électronique défaillant uniquement à partir d'images de rayonnements lumineux.

Il est alors possible de sonder le circuit intégré défaillant de façon à analyser chaque module électronique potentiellement défaillant pour identifier le module électronique défaillant.

Afin de sonder, le circuit intégré, il peut être nécessaire de percer le circuit intégré pour atteindre certains modules électroniques potentiellement défaillants. Sonder le circuit intégré pour détecter le module électronique défaillant est donc complexe et peut prendre du temps.

En outre, des modules électroniques défaillants peuvent également émettre parfois un rayonnement lumineux alors que les signaux générés par ces modules électroniques sont incorrects.

Une autre solution pour identifier un module électronique défaillant est d'inclure un système de test dans le circuit intégré, tel qu'un système BIST (acronyme de l'anglais « Buit-in-self-test »). Un tel système de test est configuré pour diagnostiquer de lui-même le circuit intégré.

Un tel système de test présente l'inconvénient d'être coûteux en termes d'occupation d'espace dans le circuit intégré et nécessite l'utilisation d'une sortie dédiée pour transmettre des informations de diagnostic à l'extérieur du circuit intégré.

Il convient donc de proposer une solution permettant d'identifier rapidement et de manière peu coûteuse des modules électroniques défaillants d'un circuit intégré.

Selon un aspect, il est proposé un circuit intégré comprenant :
- des modules électroniques, chaque module électronique étant configuré pour générer en sortie une tension, dite tension de fonctionnement, qui lui est propre lors d'un fonctionnement normal de ce module électronique,
- au moins un circuit électronique de contrôle comprenant un composant électronique émissif, chaque circuit électronique de contrôle étant disposé en sortie d'un module électronique, ledit au moins un circuit électronique de contrôle et son composant électronique émissif étant configurés de façon à permettre au composant électronique émissif d'émettre un rayonnement lumineux en fonction de la valeur de la tension en sortie de ce module électronique par rapport à la valeur de ladite tension de fonctionnement,
le circuit intégré étant configuré de sorte que le rayonnement lumineux pouvant être émis par ledit composant électronique émissif puisse se diffuser jusqu'à une face extérieure du circuit intégré.

Le rayonnement lumineux pouvant être produit par le composant électronique émissif peut donc être observé depuis l'extérieur du circuit intégré sur ladite face extérieure du circuit intégré.

Ledit au moins un circuit électronique de contrôle permet donc de signaler grâce au rayonnement lumineux pouvant être produit par ledit composant électronique émissif si un module électronique placé en amont de ce circuit électronique de contrôle dans le circuit intégré est défaillant ou non. En effet, le rayonnement lumineux est produit en fonction de la valeur de la tension en sortie du module électronique auquel le circuit électronique de contrôle est relié par rapport à une tension de sortie attendue lors d'un fonctionnement normal de ce module électronique (c'est-à-dire ladite tension de fonctionnement).

L'utilisation dudit au moins un circuit électronique de contrôle permet donc de faciliter un diagnostic d'un tel circuit intégré suite à une défaillance d'un module électronique. En effet, l'identification de modules électroniques défaillants est facilitée par ledit au moins un circuit électronique de contrôle.

En particulier, pour diagnostiquer un tel circuit intégré suite à une défaillance d'un module électronique, il est possible d'identifier le module électronique défaillant en analysant les rayonnements lumineux pouvant être produits par ledit composant électronique émissif.

L'analyse des rayonnements lumineux pouvant être produits par ledit composant électronique émissif peut être réalisée à partir d'une acquisition d'au moins une image des rayonnements lumineux produits par le circuit intégré depuis ladite face extérieure du circuit intégré.

Or, il est possible de connaître facilement l'emplacement dudit au moins un circuit électronique de contrôle dans le circuit intégré en étudiant son architecture. Ainsi, il est alors facile d'étudier un état d'émission du composant électronique émissif dudit au moins un circuit électronique de contrôle à partir de ladite au moins une image acquise des rayonnement lumineux produits par le circuit intégré au niveau des emplacements dudit au moins un circuit électronique de contrôle.

L'analyse de l'état d'émission du composant électronique émissif dudit au moins un circuit électronique de contrôle permet de connaître si un module électronique placé en amont de ce circuit électronique de contrôle est défaillant ou non.

Cette analyse simplifie donc l'identification des modules électroniques défaillants en permettant de contrôler en au moins un point du circuit intégré le fonctionnement des modules électroniques placés en amont de ce point.

En outre, l'utilisation dudit au moins un circuit électronique de contrôle permet de se dispenser d'une comparaison entre des images des rayonnements lumineux du circuit intégré défaillant et des images des rayonnements lumineux d'un circuit intégré identique mais fonctionnel.

Par ailleurs, ledit au moins un circuit électronique de contrôle présente l'avantage d'occuper un espace restreint du circuit intégré.

En outre, ledit au moins un circuit électronique de contrôle présente également l'avantage de ne pas impacter le fonctionnement du circuit intégré.

Dans un mode de réalisation avantageux, ledit au moins un circuit électronique de contrôle et son composant électronique émissif sont configurés de façon à permettre au composant électronique émissif d'émettre un rayonnement lumineux lorsque la valeur de la tension en sortie de ce module électronique atteint la valeur de ladite tension de fonctionnement. Le composant électronique émissif d'un circuit électronique de contrôle émet alors un rayonnement lumineux uniquement lorsque le module électronique auquel est relié ce circuit électronique de contrôle fonctionne correctement.

En variante, ledit au moins un circuit électronique de contrôle et son composant électronique émissif sont configurés de façon à permettre au composant électronique émissif d'émettre un rayonnement lumineux lorsque la valeur de la tension en sortie de ce module électronique est inférieure à la valeur de ladite tension de fonctionnement.

Dans ce dernier cas, le composant électronique émissif d'un circuit électronique de contrôle émet alors un rayonnement lumineux uniquement lorsque le module électronique auquel est relié ce circuit électronique de contrôle ne fonctionne pas correctement.

La consommation énergétique du circuit électronique de contrôle est ainsi réduite. En effet, le composant électronique émissif dudit au moins un circuit électronique de contrôle ne consomme pas d'énergie lorsque chaque module électronique placé en amont de ce circuit électronique de contrôle dans le circuit intégré fonctionne correctement.

Dans un mode de réalisation avantageux, aucune ligne (ou piste) métallique pouvant obstruer le rayonnement lumineux du composant électronique émissif n'est disposée entre le composant électronique émissif et ladite face extérieure du circuit intégré.

Les rayonnements lumineux pouvant être produits par le composant électronique émissif dudit au moins un circuit électronique de contrôle peuvent alors être facilement observés depuis ladite face extérieure du circuit intégré. Ladite face extérieure du circuit intégré peut être une face frontale du circuit intégré ou bien une face arrière du circuit intégré.

Dans un mode de réalisation avantageux, le rayonnement lumineux est visible ou bien infrarouge. En particulier, ce rayonnement lumineux peut présenter une longueur d'ondes comprise entre 400nm (visible) et 1400nm (proche infrarouge).

Dans un mode de réalisation avantageux, le composant électronique émissif est une diode, par exemple une diode NWell.

En particulier, la diode produit un rayonnement lumineux lorsqu'elle est passante.

De préférence, le circuit électronique comprend alors une résistance disposée en série par rapport à la diode et reliée à une masse. Cette résistance est configurée pour définir le courant passant dans la diode.

En variante, le composant électronique émissif peut-être un transistor, notamment un transistor MOS.

En particulier, le transistor produit un rayonnement lumineux lorsqu'il est passant. Le transistor peut ainsi être contrôlé par la tension en sortie du module électronique auquel est relié le circuit électronique de contrôle comprenant ce transistor.

Dans un mode de réalisation avantageux, le circuit intégré comprend des moyens de mise hors tension dudit au moins un circuit électronique de contrôle.

De tels moyens de mise hors tension permettent de réduire la consommation d'énergie du circuit intégré.

Selon un autre aspect, il est proposé un procédé de diagnostic d'un circuit intégré tel que décrit précédemment, dans lequel on met sous tension le circuit intégré puis on identifie au moins un module électronique défaillant à l'aide du composant électronique émissif dudit au moins un circuit électronique de contrôle.

Un tel procédé de diagnostic est simple et peu coûteux à mettre en œuvre.

De préférence, on procède à une acquisition d'au moins une image de ladite face extérieure du circuit intégré, l'acquisition étant adaptée pour capter les rayonnements lumineux produits par le circuit intégré sur ladite face extérieure du circuit intégré, l'identification d'au moins un module électronique défaillant étant réalisée à partir de ladite au moins une image acquise en analysant un état d'émission du composant électronique émissif dudit au moins un circuit électronique de contrôle.

D'autres avantages et caractéristiques de l'invention apparaîtront à l'examen de la description détaillée de modes de mise en œuvre et de réalisation, nullement limitatifs, et des dessins annexés sur lesquels :
[Fig 1]
[Fig 2]
[Fig 3]

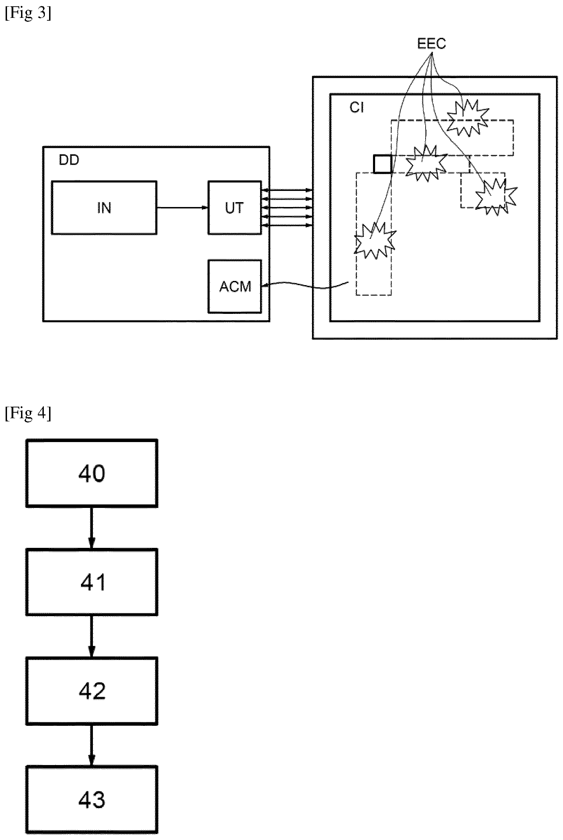

[Fig 4] illustrent schématiquement des modes de réalisation et de mise en œuvre de l'invention.

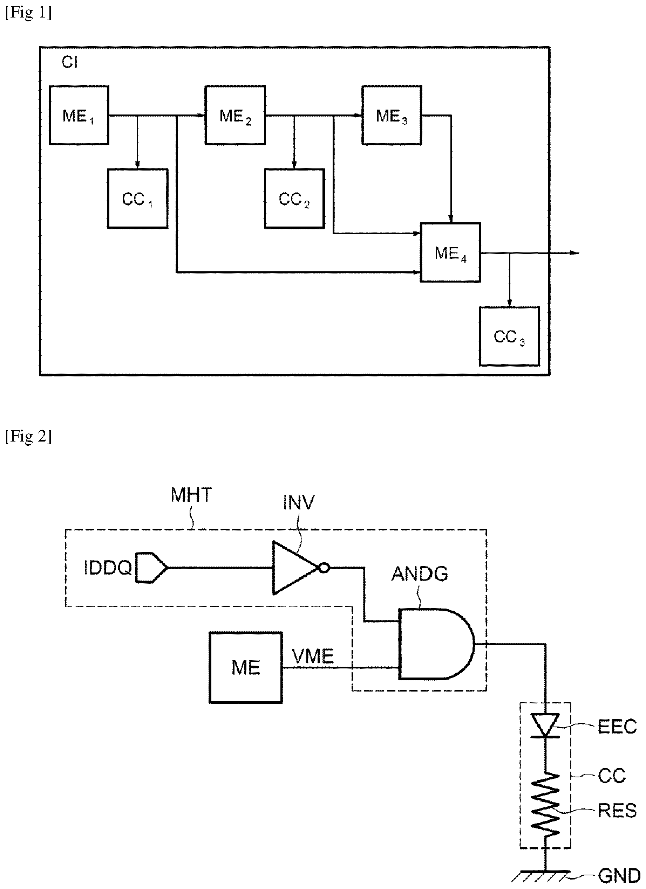

La figure 1 illustre un circuit intégré CI selon un mode réalisation de l'invention.

Le circuit intégré CI se présente sous la forme d'une plaquette (plus connue par l'appellation anglophone « die »). Le circuit intégré CI présente ainsi une face frontale et une face arrière, non représentée.

Le circuit intégré CI comprend des modules électroniques ME₁, ME₂, ME₃, ME₄. Chaque module électronique ME₁, ME₂, ME₃, ME₄ est configuré pour réaliser une fonction électronique donnée du circuit intégré.

Chaque module électronique peut être analogique ou bien numérique. Par exemple, chaque module électronique ME₁, ME₂, ME₃, ME₄ peut être choisi parmi un amplificateur, un dispositif de régulation de potentiel, un oscillateur et un convertisseur analogique-numérique.

Chaque module électronique ME₁, ME₂, ME₃, ME₄ est configuré pour générer en sortie de ce module électronique une tension, dite tension de fonctionnement, qui lui est propre lorsque ce module électronique fonctionne correctement.

Néanmoins, il est possible que des modules électroniques ME₁, ME₂, ME₃, ME₄ du circuit intégré subissent des défaillances. Ces défaillances peuvent notamment résulter de la fabrication du circuit intégré CI ou bien de leur usure dans le temps. Ainsi, dès lors qu'un module électronique ME₁, ME₂, ME₃, ME₄ est défaillant, ce module électronique ne peut plus produire ladite tension de fonctionnement. La tension en sortie de ce module électronique ME₁, ME₂, ME₃, ME₄ est alors nulle.

Le circuit intégré CI comprend également au moins un circuit électronique de contrôle CC₁, CC₂, CC₃.

Chaque circuit électronique de contrôle CC₁, CC₂, CC₃ est disposé en sortie d'un module électronique ME₁, ME₂, ME₄ différent du circuit intégré. En particulier, le circuit électronique de contrôle CC₁ est relié à la sortie du module électronique ME₁,le circuit électronique de contrôle CC₂ est relié à la sortie du module électronique ME₂, le circuit électronique de contrôle CC₃ est relié à la sortie du module électronique ME4.

Chaque circuit électronique de contrôle CC₁, CC₂, CC₃ permet de contrôler le bon fonctionnement du module électronique auquel il est relié.

Chaque circuit électronique de contrôle CC comprend un composant électronique émissif EEC, comme représenté à la figure 2. Ce composant électronique émissif EEC est relié à la sortie du module électronique ME auquel est relié le circuit électronique de contrôle CC comprenant ce composant électronique émissif EEC.

Chaque circuit électronique de contrôle CC et son composant électronique émissif EEC sont configurés de sorte que le composant électronique émissif EEC puisse produire un rayonnement lumineux en fonction de la valeur de la tension en sortie du module électronique ME auquel ce composant électronique est relié par rapport à la valeur de la tension de fonctionnement de ce module électronique ME.

Le composant électronique émissif EEC de chaque circuit électronique de contrôle CC peut ainsi présenter deux états d'émission possibles. Dans un premier état d'émission, ce composant électronique émissif EEC émet un rayonnement lumineux. Dans l'autre état d'émission, le composant électronique émissif EEC n'émet aucun rayonnement lumineux.

Plus particulièrement, dans un mode de réalisation, chaque circuit électronique de contrôle CC et son composant électronique émissif EEC sont configurés de façon à permettre au composant électronique émissif EEC d'émettre un rayonnement lumineux lorsque la tension en sortie de ce module électronique ME atteint ladite tension de fonctionnement de ce module électronique ME. Le composant électronique émissif EEC du circuit électronique de contrôle CC émet alors un rayonnement lumineux uniquement lorsque le module électronique ME auquel est relié ce circuit électronique de contrôle CC fonctionne correctement.

En variante, ledit au moins un circuit électronique de contrôle CC et son composant électronique émissif EEC sont configurés de façon à permettre au composant électronique émissif EEC d'émettre un rayonnement lumineux lorsque la tension en sortie de ce module électronique ME est inférieure à ladite tension de fonctionnement.

Dans ce cas, le composant électronique émissif EEC du circuit électronique de contrôle CC émet alors un rayonnement lumineux uniquement lorsque le module électronique ME auquel est relié ce circuit électronique de contrôle CC ne fonctionne pas correctement.

La consommation énergétique du circuit électronique de contrôle est ainsi réduite. En effet, le composant électronique émissif dudit au moins un circuit électronique de contrôle ne consomme pas d'énergie lorsque chaque module électronique placé en amont de ce circuit électronique de contrôle dans le circuit intégré fonctionne correctement.

Le rayonnement lumineux pouvant être émis par le composant électronique émissif EEC peut être visible ou bien infrarouge. En particulier, ce rayonnement lumineux peut présenter une longueur d'ondes comprise entre 400nm (visible) et 1400nm (proche infrarouge).

Comme illustré à la figure 2, le composant électronique émissif EEC peut être une diode, par exemple une diode NWell.

Le circuit électronique de contrôle CC comprend alors une résistance RES disposée en série par rapport à la diode EEC et reliée à une masse GND. Cette résistance est configurée pour définir le courant passant dans la diode EEC.

En particulier, la diode produit un rayonnement lumineux lorsqu'elle est passante.

Par ailleurs, le circuit intégré CI comprend des lignes métalliques (ou pistes métalliques), non représentées, utilisées pour connecter différents composants électroniques du circuit intégré CI.

Néanmoins, de préférence, aucune ligne métallique pouvant obstruer le rayonnement lumineux du composant électronique émissif EEC n'est disposée dans le circuit intégré CI entre le composant électronique émissif EEC et une face extérieure du circuit intégré, en particulier la face frontale ou bien la face arrière du circuit intégré.

Les rayonnements lumineux pouvant être produits par le composant électronique émissif EEC peuvent alors être facilement observés depuis cette face extérieure du circuit intégré CI.

Par ailleurs, de préférence, le circuit intégré CI comprend des moyens de mise hors tension MHT pour chaque circuit électronique de contrôle. Les moyens de mise hors tension MHT sont configurés pour mettre hors tension le circuit électronique auquel ils sont reliés.

En particulier, comme représenté à la figure 2, les moyens de mise hors tension MHT peuvent comprendre une porte logique ANDG permettant de réaliser une fonction logique ET (AND). Cette porte logique ANDG reçoit en entrée le signal VME en sortie du module électronique ME auquel le circuit électronique de contrôle CC est relié ainsi qu'un signal de mise hors tension IDDQ inversé par une porte inverseuse INV. La porte logique ET présente une sortie reliée au circuit électronique de contrôle CC. Ainsi, lorsque le signal de mise hors tension est dans un état haut pour mettre hors tension le circuit électronique de contrôle CC, la porte logique ET génère un signal à l'état bas quel que soit le signal en sortie du module électronique ME. La tension en entrée du circuit électronique de contrôle CC est donc nulle.

De tels moyens de mise hors tension MHT permettent donc de réduire la consommation d'énergie du circuit intégré en mettant hors tension le circuit électronique de contrôle CC auquel ils sont reliés.

Chaque circuit électronique de contrôle CC permet de signaler, grâce au rayonnement lumineux pouvant être produit par son composant électronique émissif EEC, si un module électronique ME placé en amont de ce circuit électronique de contrôle CC dans le circuit intégré CI est défaillant ou non.

En effet, le rayonnement lumineux est produit en fonction de la valeur de la tension en sortie du module électronique auquel le circuit électronique de contrôle est relié par rapport à une valeur de tension de sortie attendue lors d'un fonctionnement normal de ce module électronique (c'est-à-dire ladite tension de fonctionnement).

L'utilisation dudit au moins un circuit électronique de contrôle CC permet de faciliter un diagnostic d'un tel circuit intégré CI suite à une défaillance d'un module électronique ME. En effet, l'identification de modules électroniques défaillants est facilitée par ledit au moins un circuit électronique de contrôle.

En particulier, pour diagnostiquer un tel circuit intégré CI suite à une défaillance d'un module électronique ME, il est possible d'identifier le module électronique ME défaillant en analysant les rayonnements lumineux pouvant être produits par ledit composant électronique émissif EEC de chaque circuit électronique de contrôle CC.

En particulier, la figure 3 illustre un dispositif de diagnostic DD permettant de diagnostiquer un circuit intégré CI tel que celui décrit précédemment comprenant au moins un module électronique défaillant.

Le dispositif de diagnostic DD comprend une entrée configurée pour recevoir un fichier de simulation comprenant notamment une séquence d'instructions à réaliser pour tester le dispositif ainsi que les états des signaux du circuit intégré attendus en réponse à ces instructions.

Le dispositif de diagnostic DD comprend une unité de test UT configurée pour pouvoir commander le circuit intégré CI à partir des instructions d'un fichier de simulation reçu par l'entrée IN et acquérir l'état des signaux du circuit intégré en réponse aux instructions.

L'unité de test UT est également configurée pour recevoir les états des signaux du circuit intégré acquis par l'unité de test et les états des signaux attendus indiqués par le fichier de simulation. L'unité d'analyse UT est également configurée pour comparer les états des signaux acquis aux états des signaux attendus indiqués par le fichier de simulation. L'unité d'analyse est également configurée pour signaler les états des signaux acquis qui diffèrent de ceux attendus à partir des résultats des comparaisons.

Par ailleurs, le dispositif de diagnostic DD comprend des moyens d'acquisition d'images ACM configurés pour capter les rayonnements lumineux produits par le circuit intégré CI visibles depuis une face extérieure du circuit intégré CI. Les moyens d'acquisition d'images ACM peuvent être une caméra configurée pour capter des rayonnements lumineux présentant une longueur d'ondes comprise entre 400nm (visible) et 1400nm (proche infrarouge).

De préférence, les moyens d'acquisition d'images ACM sont disposés de façon à pouvoir acquérir une image des rayonnements lumineux visibles depuis la face arrière du circuit intégré CI.

La figure 4 représente un procédé de diagnostic pouvant être mis en œuvre par le dispositif de diagnostic décrit précédemment.

Afin de réaliser ce procédé de diagnostic, on récupère une information sur les emplacements des composants électroniques émissifs dans le circuit intégré de façon à faciliter l'identification de ces composants électroniques émissifs.

En outre, on récupère une information sur un état d'émission attendu du composant électronique émissif de chaque circuit électronique de contrôle du circuit intégré CI lorsque le module électronique placé en amont de ce circuit électronique de contrôle est fonctionnel ou défaillant.

On utilise également un fichier de simulation tel que décrit précédemment reçu en entrée IN du dispositif de diagnostic DD.

Le procédé comprend tout d'abord une étape 40 de mise sous tension du circuit intégré CI. Cette étape 40 de mise sous tension permet d'enclencher une phase de démarrage du circuit intégré CI. Cette mise sous tension peut être commandée par l'unité de test UT à partir du fichier de simulation.

Lors de cette phase de démarrage, les modules électroniques défaillants ne délivrent pas en sortie une tension correcte, c'est-à-dire leur tension de fonctionnement.

Puis, lors d'une étape 41, l'unité de test UT commande le circuit intégré CI selon les instructions du fichier de simulation.

Le procédé comprend en outre une étape 42 d'acquisition dans laquelle les moyens d'acquisition d'images ACM réalisent une acquisition d'une image des rayonnements lumineux du circuit intégré CI défaillant pendant que l'unité de test commande le circuit intégré selon les instructions du fichier de simulation.

De préférence, plusieurs images des rayonnements lumineux sont acquises à différents instants lorsque l'unité de test UT commande le circuit intégré de façon à obtenir une séquence d'états d'émission des composants émissifs.

Le procédé comprend ensuite une étape 42 d'analyse dans laquelle les images acquises sont analysées de façon à identifier l'état d'émission du composant électronique émissif de chaque circuit électronique de contrôle.

L'analyse de l'état d'émission du composant électronique émissif de chaque circuit électronique de contrôle permet de savoir si le module électronique placé en amont de ce circuit électronique de contrôle est fonctionnel ou bien qu'un des modules électroniques placés en amont de ce composant électronique émissif est défaillant.

Ainsi, une fois les états d'émission des composants électroniques émissifs identifiés, le procédé comprend une étape 43 d'identification des modules électroniques défaillants.

En particulier, on compare les états d'émission identifiés des composants électroniques émissifs aux états d'émission attendus des composants électroniques émissifs.

Cette comparaison permet de savoir si les états d'émission identifiés des composants électroniques émissifs sont différents des états d'émission attendus des composants électroniques émissifs.

Les modules électroniques sont ensuite identifiés à partir des résultats de ces comparaisons. En particulier, si l'état d'émission identifié d'un composant électronique émissif est différent de l'état d'émission attendu pour ce composant électronique émissif, alors un module électronique placé en amont de ce composant électronique émissif est défaillant.

Les étapes 42 et 43 d'analyse et d'identification des modules défaillants peuvent être réalisées par une personne ou bien automatiquement par une unité de traitement.

Par ailleurs, afin de simplifier l'identification des modules défaillants, l'unité de test du dispositif de diagnostic peut être utilisée pour identifier le module électronique à partir duquel des signaux peuvent être défaillants. Cela permet de réduire le nombre de modules électroniques à analyser à partir de ladite au moins une image acquise pour identifier le(s) module(s) électronique(s) défaillant(s).

Un tel procédé de diagnostic simplifie donc l'identification des modules électroniques défaillants en permettant de contrôler en au moins un point du circuit intégré le fonctionnement des modules électroniques placés en amont de ce point.

En outre, l'utilisation dudit au moins un circuit électronique de contrôle permet de se dispenser d'une comparaison entre des images des rayonnements lumineux du circuit intégré défaillant et des images des rayonnements lumineux d'un circuit intégré identique mais fonctionnel, tel que cela est réalisé dans les procédés de diagnostic connus. En effet, il suffit de connaître les états d'émission des composants émissifs d'un circuit intégré fonctionnels suivant les instructions du fichier de simulation pour identifier les modules défaillants d'un circuit intégré défaillant.

Par ailleurs, ledit au moins un circuit électronique de contrôle présente l'avantage d'occuper un espace restreint du circuit intégré.

En outre, ledit au moins un circuit électronique de contrôle présente également l'avantage de ne pas impacter le fonctionnement du circuit intégré.

Bien entendu, la présente invention est susceptible de diverses variantes et modifications qui apparaîtront à l'homme de l'art. Par exemple, en variante d'une diode, le composant électronique émissif peut être un transistor, par exemple un transistor MOS. Le transistor produit alors un rayonnement lumineux lorsqu'il est passant. Le transistor peut ainsi être contrôlé par la tension en sortie du module électronique auquel est relié le circuit électronique de contrôle comprenant ce transistor.

## Revendications

1. Circuit intégré comprenant :
- des modules électroniques (ME, ME₁, ME₂, ME₃, ME₄), chaque module électronique étant configuré pour générer en sortie une tension, dite tension de fonctionnement, qui lui est propre lors d'un fonctionnement normal de ce module électronique,
- au moins un circuit électronique de contrôle (CC, CC₁, CC₂, CC₃) comprenant un composant électronique émissif (EEC), chaque circuit électronique de contrôle (CC, CC₁, CC₂, CC₃) étant disposé en sortie d'un module électronique (ME, ME₁, ME₂, ME₃, ME₄), ledit au moins un circuit électronique de contrôle (CC, CC₁, CC₂, CC₃) et son composant électronique émissif (EEC) étant configurés de façon à permettre au composant électronique émissif (EEC) d'émettre un rayonnement lumineux en fonction de la valeur de la tension en sortie de ce module électronique (ME, ME₁, ME₂, ME₃, ME₄) par rapport à la valeur de ladite tension de fonctionnement,
le circuit intégré étant configuré de sorte que le rayonnement lumineux pouvant être émis par ledit composant électronique émissif (EEC) puisse se diffuser jusqu'à une face extérieure du circuit intégré.

2. Circuit intégré selon la revendication 1, dans lequel ledit au moins un circuit électronique de contrôle (CC, CC₁, CC₂, CC₃) et son composant électronique émissif (EEC) sont configurés de façon à permettre au composant électronique émissif (EEC) d'émettre un rayonnement lumineux lorsque la valeur de la tension en sortie de ce module électronique (ME, ME₁, ME₂, ME₃, ME₄) atteint la valeur de ladite tension de fonctionnement.

3. Circuit intégré selon la revendication 1, dans lequel ledit au moins un circuit électronique de contrôle (CC, CC₁, CC₂, CC₃) et son composant électronique émissif (EEC) sont configurés de façon à permettre au composant électronique émissif (EEC) d'émettre un rayonnement lumineux lorsque la valeur de la tension en sortie de ce module électronique (ME, ME₁, ME₂, ME₃, ME₄) est inférieure à la valeur de ladite tension de fonctionnement.

4. Circuit intégré selon l'une des revendications 1 à 3, dans lequel aucune ligne métallique pouvant obstruer le rayonnement lumineux du composant électronique émissif (EEC) n'est disposée entre le composant électronique émissif (EEC) et ladite face extérieure du circuit intégré.

5. Circuit intégré selon l'une des revendications 1 à 4, dans lequel le rayonnement lumineux présente une longueur d'ondes comprise entre 400nm et 1400nm.

6. Circuit intégré selon l'une des revendications 1 à 5, dans lequel le composant électronique émissif (EEC) est une diode.

7. Circuit intégré selon la revendication 6, dans lequel la diode est une diode NWell.

8. Circuit intégré selon l'une des revendications 1 à 5, dans lequel le composant électronique émissif (EEC) est un transistor.

9. Circuit intégré selon l'une des revendications 1 à 8, comprenant des moyens de mise hors tension dudit au moins un circuit électronique de contrôle (CC, CC₁, CC₂, CC₃).

10. Procédé de diagnostic d'un circuit intégré (CI) selon l'une des revendications 1 à 9 dans lequel on met sous tension (40) le circuit intégré (CI) puis on identifie (43) au moins un module électronique défaillant à l'aide du composant électronique émissif (EEC) dudit au moins un circuit électronique de contrôle (CC, CC₁, CC₂, CC₃).

11. Procédé selon la revendication 10, dans lequel on procède à une acquisition (42) d'au moins une image de ladite face extérieure du circuit intégré (CI), l'acquisition étant adaptée pour capter les rayonnements lumineux produits par le circuit intégré (CI) sur ladite face extérieure du circuit intégré (CI), l'identification (43) d'au moins un module électronique défaillant étant réalisée à partir de ladite au moins une image acquise en analysant un état d'émission du composant électronique émissif (EEC) dudit au moins un circuit électronique de contrôle (CC, CC₁, CC₂, CC₃).
